# EUROPEAN PATENT APPLICATION

(11) **EP 1 378 718 A1**
(43) Date of publication of application: **07.01.2004**
(21) Application number: 02291703.3
(22) Date of filing: 05.07.2002
(51) Int. Cl.: F28D 20/02, H05K 7/20

(54) **Housing for electronic equipment**

(71) Applicant: ALCATEL, 75008 Paris (FR)
(72) Inventor: Gonzalez Martinez, Maria, 28820 Coslada - Madrid (ES); Callejon Brondo, Francisco, 28022 Madrid (ES)
(74) Representative: Lamoureux, Bernard

(57) **Abstract**

Housing (11) comprised by several walls defining an inner space destined to contain telecommunications equipment (13) generating heat while operating.

Said heat is evacuated to outside the housing (11) by means of an interchanger (12) having a phase change material adapted to absorb the heat inside the housing (11) when the inside temperature reaches and/or exceeds a predetermined value.

## Description

### OBJECT OF THE INVENTION

The present invention refers to a suitable housing for containing electronic equipment and, more particularly, a cabinet for containing telecommunications equipment.

### STATE OF THE ART

Telecommunications equipment is generally installed inside buildings, in cabinets which can, in turn, be located outdoors or underground, etc., and generates heat during operation. This heat needs to be evacuated to prevent deterioration of the telecommunications equipment, thus avoiding possible interruption to the telecommunications service.

Usually, along with the telecommunications equipment there is equipment handling the evacuation of generated heat to outside the cabinet in which the equipment is installed.

In the case of the telecommunications equipment being installed inside a cabinet out of doors, to the heat generated by the telecommunications equipment there has to be added the heat from the climate of the site where the cabinet is located, i.e., the effect of solar radiation. Thus, the equipment evacuating the heat from inside the cabinet has to evacuate the heat generated by the telecommunications equipment and that produced by solar radiation.

The cooling equipment consumes electrical energy on evacuating heat from inside the cabinet or from an enclosure where the telecommunications equipment is located. Such consumer cost is borne by the operating company proprietor of the telecommunications equipment, hence provider of the telecommunications service.

It is to be indicated that the climatic conditions at the location where telecommunications equipment is installed are harsher or more extreme than the conditions in the room where the maintenance personnel for such equipment is to be found. That is to say, the temperature of the room where control and supervision of the telecommunications equipment is carried out by maintenance personnel is several degrees higher than the temperature in the cabinet occupied by the telecommunications equipment.

Accordingly, it becomes necessary to develop a system avoiding electrical energy consumption, for the evacuation of heat from the housing occupied by telecommunications equipment, with the object of lowering the installation and maintenance costs of the telecommunication operator's outside facilities.

### CHARACTERIZATION OF THE INVENTION

To overcome the disadvantages mentioned above, the present invention provides a cabinet comprised by several walls defining an inner space, destined to contain telecommunications equipment generating heat during operation.

Said heat is evacuated to the outside of the cabinet by an interchanger means having a phase change material adapted for absorbing the heat inside the cabinet, when the inside temperature thereof reaches and/or exceeds a predetermined value. That is to say, the phase change material absorbs the inside heat of the cabinet and utilizes it to change phase, for example, from solid to liquid.

The heat stored by the phase change material is released outside the cabinet when the outside temperature is such as to allow the phase change material to return to its initial or stationary phase.

Thus, the interchanger prevents the inside temperature of the cabinet from reaching a dangerous value for the telecommunications equipment, without consuming electrical energy to keep the temperature within a suitable temperature range for the electronic equipment housed inside the cabinet.

Another advantage of the interchanger incorporating the phase change material and deriving from the foregoing is the lowering of expense in maintaining the cabinet cooling system, inasmuch as there is no equipment to be maintained. It can be said that the interchanger means is maintenance free.

Another interesting advantage is that the battery, which cabinets located out of doors usually possess, can supply energy to the telecommunications equipment over a longer period of time, since the interchanger, having a phase change material, does not need to consume energy from the batteries in order to evacuate the heat from inside the cabinet, the interchanger is a passive system.

### BRIEF OUTLINE OF THE FIGURES

A more detailed explanation of the invention is given in the following description based on the attached figures in which:

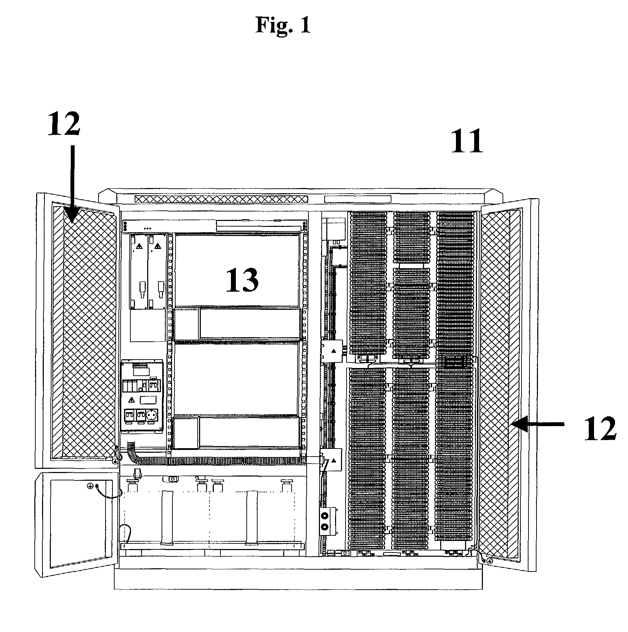

- Figure 1 shows a front view of a cabinet according to the invention.

### DESCRIPTION OF THE INVENTION

Figure 1 shows a front view of a cabinet 11 which, in the space inside delimited by its walls, has an electronic equipment 13 such as a telecommunications equipment.

The electronic components 13 comprising the telecommunications equipment while it is operating, that is, while providing communication services to subscribers of the operator who is commercially exploiting the telecommunications equipment, generate heat which needs to be evacuated towards the outside of the cabinet 11, with the object of avoiding their destruction as the result of ongoing high temperature inside the cabinet. Obviously, solar radiation also influences the temperature inside the cabinet 13.

For such reason, inside the cabinet 11 an interchanger means 12 is installed, carrying out the task of extracting the heat generated by the electronic components of the telecommunications equipment 13, as well as the temperature increase due to solar radiation.

The interchanger 12 comprises a phase change material which absorbs the heat inside the cabinet 11, when the inside temperature of the cabinet 11 reaches and/or exceeds a predetermined value, to keep the telecommunications equipment 13 in good working order.

It uses the heat absorbed by the phase change material to pass from one material state to another; for example, the material passes from solid state to liquid state. Once the outside temperature of the cabinet 11 is lower than the predetermined temperature value at which change of phase of the material occurs, the heat stored by said material is released into the air around the outside of the cabinet 11. Hence, the phase change material changes phase and passes from a liquid to a solid state of the material. Usually this change of phase takes place overnight when the outside temperature falls as a result of the absence of solar radiation.

Similarly, it can occur that the interchanger 12, that is, the phase change material, releases the heat that builds up inside the cabinet 11, due to the temperature inside the cabinet 11 being lower than the predetermined temperature value.

The interchanger 12 is arranged so as to be installed in the inner face of any of the walls which delimit the space inside the cabinet, including the roof. Obviously, the heat interchanger 12 is designed for the work and environmental conditions surrounding the telecommunications equipment 13 and thus able to occupy one or several inside walls of the cabinet 11. In no case will there be direct contact between the telecommunications equipment 13 and the interchanger 12.

To favour the heat extraction process and, moreover, avoid specific over-heated zones, the interchanger 12 can have a first fan or fans (no shown) which will move the air inside the cabinet 11.

Similarly, to favour release of the heat towards the outside, the interchanger 12 can also contain a second fan (no shown) which will move the outside air surrounding the cabinet 11. To prevent entry of dust from the outside, both groups of fans will be insulated.

From all that that has been mentioned thus far, it can be said that the interchanger 12 having a phase change material is a passive system, since it does not consume electrical energy to evacuate heat from inside the cabinet 11 towards the outside. This, obviously, disregards the minimum consumption by the sets of fans.

## Claims

1. **Housing for electronic equipment** comprised by several walls destined to contain electronic equipment (13) generating heat while operating; it includes an interchanger (12) means which evacuates the heat from inside the cabinet (11) to outside the same; **characterized in that** the interchanger (12) means comprises a phase change material which is adapted to absorb the heat inside the cabinet (11) when the inside temperature of the cabinet (11) reaches and/or exceeds a predetermined value, to keep the electronic equipment (13) in good working order.

2. **Housing** according to claim 1; the interchanger (12) means is adapted to release the heat absorbed by the phase change material outside the cabinet (11), when the outside temperature of the cabinet (11) is lower than the predetermined temperature value.

3. **Housing** according to claim 2; the interchanger means is also arranged in order to release the heat absorbed by the phase change material inside the cabinet (11), when the inside temperature of the cabinet (11) is lower than the predetermined temperature value.

4. **Housing** according to claim 1; the interchanger means is arranged in order to be installed in an inside face of at least one wall of the cabinet 811) and without coming into contact with the electronic equipment (13).

5. **Housing** according to claim 4; the interchanger means (12) includes at least one suitable first means for moving the air inside the cabinet (11) and around the electronic equipment (13).

6. **Housing** according to claim 5; the interchanger means (12) includes at least one suitable second means for moving the outside air surrounding the cabinet (11).

7. **Housing** according to claims 5 and 6; where the first and second suitable means for moving the air is a fan, respectively.

8. **Interchanger means** for extracting heat from a cabinet (11); including a phase change material which is adapted in order to maintain the inside temperature of the cabinet (13) within a temperature range apt for correct operation of electronic equipment (13) housed inside the cabinet (11).

9. **Interchanger means** according to claim 8, likewise comprising a suitable means for moving the air inside the cabinet (11).

10. **Interchanger means** according to claim 9, moreover including a suitable means for moving the air outside the cabinet (11).

11. **Interchanger means** according to claim 10, being adapted to be installed in the inside face of a wall forming the cabinet (11).

12. **Interchanger means** according to claims 9 and 10, the suitable means for moving the air being **fans**.

13. **Electronic equipment** according any preceding claims is telecommunications equipment (13).
